# EUROPEAN PATENT APPLICATION

(11) **EP 4 657 668 A1**
(43) Date of publication of application: **03.12.2025**
(21) Application number: 24813816.6
(22) Date of filing: 14.03.2024
(51) Int. Cl.: H01R 12/59, H05K 1/11

(54) **SIM CARD HOLDER AND TERMINAL DEVICE**

(30) Priority: 31.05.2023 CN 202321374868 U
(71) Applicant: Honor Device Co., Ltd., Shenzhen, Guangdong 518040 (CN)
(72) Inventor: YAN, Bin, Shenzhen, Guangdong 518040 (CN); ZHOU, Guotong, Shenzhen, Guangdong 518040 (CN); WANG, Xuyang, Shenzhen, Guangdong 518040 (CN); LI, Houcun, Shenzhen, Guangdong 518040 (CN)
(74) Representative: Gill Jennings & Every LLP
(86) International application number: PCT/CN2024/081777
(87) International publication number: WO 2024/244610

(57) **Abstract**

Embodiments of this application relate to the field of communication technologies, and provide a SIM card tray and a terminal device. The SIM card tray includes a base and a flexible circuit board. The base has edge side portions, and a plurality of pads are arranged on the base. Each pad is close to an edge side portion. An end of the flexible circuit board is connected to one of the edge side portions, and a projection of a bending start position of the flexible circuit board on a current edge side portion does not coincide with a projection of a corresponding pad on the same edge side portion. In the SIM card tray according to an embodiment of this application, the flexible circuit board is arranged on the edge side portions of the base. In addition, the bending start position of the flexible circuit board is misaligned with a position of the corresponding pad on the current edge side portion. In this way, when the flexible circuit board is bent during connection to a circuit board of the terminal device, the flexible circuit board does not drive a welding region of the base at which the corresponding pad is located. Therefore, there is less stress on the pad in the welding region of the base, the pad is not susceptible to dropping, and welding reliability is higher.

## Description

This application claims priority to Chinese Patent Application No. 202321374868.9, filed with the China National Intellectual Property Administration on May 31, 2023 and entitled "SIM CARD TRAY AND TERMINAL DEVICE", which is incorporated herein by reference in its entirety.

### TECHNICAL FIELD

This application relates to the technical field of electronic devices, and in particular, to a SIM card tray and a terminal device with the SIM card tray.

### BACKGROUND

A SIM (Subscriber Identity Module) card is an integrated circuit card held by a mobile subscriber of a global communication system, and is also referred to as a subscriber identity card. Each mobile terminal can only access a network for use through a SIM card. Therefore, each terminal device is provided with a SIM card tray for a SIM card to be inserted in.

Currently, a SIM card tray and a circuit board in a mobile device are arranged in two manners. One manner is that the SIM card tray and the circuit board are integrally arranged, that is, the SIM card tray is directly electrically connected to the circuit board. This solution has an advantage of low costs, but the SIM card tray and the circuit board are stacked in a thickness direction, and therefore, a large thickness space needs to be occupied. The other manner is that the SIM card tray and the circuit board are arranged in a separated manner, a flexible circuit board is arranged on the SIM card tray, and the SIM card tray is electrically connected to the circuit board on the terminal device by using the flexible circuit board. The manner has an advantage that a thickness space can be further compressed, which is applicable to a terminal device with a higher requirement for lightening and thinning.

However, the flexible circuit board needs to be bent in an electrical connection process. In addition, to not reduce a connection strength between a pad and a base, generally, an avoidance width of 0.5 to 1 mm needs to be reserved between the flexible circuit board and the pad in a bending direction. In this way, more reserved space is needed in a transverse direction for arrangement of the SIM card tray and the circuit board in a separated manner.

### SUMMARY

### TECHNICAL PROBLEM

Embodiments of this application provide a SIM card tray and a terminal device, aiming at resolving a technical problem of low reliability of a welded structure of a SIM card tray.

### TECHNICAL SOLUTION

To solve the above technical problem, the technical solutions used in embodiments of this application are as follows:
According to a first aspect, an embodiment of this application provides a SIM card tray, including a base and a flexible circuit board, where the base has edge side portions, a plurality of pads are arranged on the base, each pad is close to an edge side portion, an end of the flexible circuit board is connected to one of the edge side portions, and a projection of a bending start position of the flexible circuit board on a current edge side portion does not coincide with a projection of a corresponding pad on the same edge side portion.

In some embodiments, only one of the pads is close to the current edge side portion, and is misaligned with the bending start position of the flexible circuit board.

By the above technical solution, the bending start position of the flexible circuit board can avoid the current pad, so that there is less stress on the current pad in a welding region of the base, and welding reliability is higher.

In some embodiments, two pads are close to the current edge side portion at an interval, and the bending start position of the flexible circuit board is located between the current two pads.

By the above technical solution, the bending start position of the flexible circuit board can avoid the current two pads, so that there is less stress on the current two pads in a welding region of the base, and welding reliability is higher.

In some embodiments, distances between two opposite ends of the bending start position of the flexible circuit board and corresponding pads are the same.

By the above technical solution, magnitudes of pulling forces on the two pads by the two opposite ends of the bending start position of the flexible circuit board are the same or basically the same. Therefore, stresses on the two pads in the welding region of the base are approximately the same, which can also improve welding reliability to a certain extent.

In some embodiments, one end of the bending start position of the flexible circuit board is close to one of the pads, and the other end thereof is away from the other pad.

By the above technical solution, there is a differentiated setting for the pulling forces on the two pads by the two opposite ends of the bending start position of the flexible circuit board, which is suitable for scenarios with different sizes or different welding strengths of the two pads.

In some embodiments, a crack arrest groove is provided at any one of the two opposite ends of the bending start position of the flexible circuit board.

By the above technical solution, the crack arrest groove is configured to reduce a stress at a joint between the flexible circuit board and the base during bending and prolong the service life of the flexible circuit board.

In some embodiments, a groove wall of the crack arrest groove is provided in an arc shape.

By the above technical solution, stress concentration of the arc-shaped crack arrest groove is less and a crack arrest effect is better.

In some embodiments, the SIM card tray further includes a card slot holder, where the card slot holder is arranged on the base, and the card slot holder is electrically connected to the base through each pad.

By the above technical solution, the card slot holder is configured for a SIM card to be inserted in, and is electrically connected to the base through each pad.

In some embodiments, a mounting portion is arranged on the base, and a mounting fitting portion fitting with the mounting portion is arranged on the card slot holder.

By the above technical solution, through the fit connection between the mounting portion and the mounting fitting portion, connection stability between the card slot holder and the base is further improved.

In some embodiments, the mounting portion includes a mounting hole provided in the base, and the mounting fitting portion includes a hook arranged on the card slot holder.

According to a second aspect, an embodiment of this application further provides a terminal device, including the above SIM card tray.

The above technical solutions in the embodiments of this application have at least the following technical effects or advantages.

In the terminal device according to the embodiment of this application, based on the above SIM card tray, the terminal device may have a smaller thickness, which is more conducive to miniaturization.

The SIM card tray according to the embodiment of this application has the following beneficial effects. In the SIM card tray according to the embodiment of this application, the flexible circuit board is arranged on the edge side portions of the base. In addition, the projection of the bending start position of the flexible circuit board on the current edge side portion does not coincide with the projection of the corresponding pad on the same edge side portion. That is, the bending start position of the flexible circuit board is misaligned with a position of the corresponding pad on the current edge side portion. In this way, when the flexible circuit board is bent during connection to a circuit board of the terminal device, the flexible circuit board does not drive the welding region of the base at which the corresponding pad is located, or only drives part of the welding region of the base at which the corresponding pad is located. Therefore, there is less stress on the pad in the welding region of the base, the pad is not susceptible to dropping, and welding reliability is higher.

The terminal device according to the embodiment of this application has the following beneficial effects. Based on the above SIM card tray, the terminal device may have a smaller thickness, which is more conducive to miniaturization.

### BRIEF DESCRIPTION OF DRAWINGS

FIG. 1 is a schematic diagram of a structure of a terminal device according to an embodiment of this application;
FIG. 2 is a schematic diagram of a structure of connection between a main control circuit board and a SIM card tray according to an embodiment of this application;
FIG. 3 is a schematic diagram of a structure of a base and a flexible circuit board of a SIM card tray according to an embodiment of this application;
FIG. 4 is another schematic diagram of a structure of a base and a flexible circuit board of a SIM card tray according to an embodiment of this application; and
FIG. 5 is a schematic diagram of a structure of a base, a flexible circuit board, and a card slot holder of a SIM card tray according to an embodiment of this application.

Reference numerals in the accompanying drawings:
1000: Terminal device; 200: Main control circuit board;
100: SIM card tray;
10: Base; 11: Edge side portion; 12: Pad;
20: Flexible circuit board; 20a: Bending start position; 20b: Crack arrest groove;
30: Card slot holder;
41: Mounting portion; 42: Mounting fitting portion.

### DESCRIPTION OF EMBODIMENTS

Embodiments of this application are described in detail below, and examples of the embodiments are shown in accompanying drawings, where the same or similar elements or the elements having same or similar functions are denoted by the same or similar reference numerals throughout the description. The embodiments described below with reference to the accompanying drawings are exemplary, and are intended to explain this application and cannot be construed as a limitation to this application.

In the description of this application, it should be understood that orientation or position relationships indicated by the terms, such as "length", "width", "thickness", "top", "bottom", "inner", "outer", "up", "down", "left", and "right", are based on orientation or position relationships shown in the accompanying drawings, and are used only for ease of describing this application and simplification of description, rather than indicating or implying that the mentioned apparatus or element needs to have a particular orientation or needs be constructed and operated in a particular orientation. Therefore, such terms should not be construed as limiting this application.

The terms, such as "first", "second", "third", and "fourth", are used for distinctive descriptions only and should not be construed as indicating or implying relative importance or implicitly indicating a quantity of technical features indicated. For example, a first push part and a second push part are merely intended for distinguishing between different push parts, and the sequence of the first push part and the second push part is not limited. The first push part may alternatively be referred to as a second push part, and the second push part may alternatively be referred to as a first push part without departing from the scope of the various described embodiments. In addition, terms, such as "first", "second", "third", and "fourth", do not limit that the indicated features are necessarily different.

In this application, unless otherwise explicitly specified or defined, the terms such as "connect" and "connection" should be understood in a broad sense. For example, the connection may be a fixed connection, a detachable connection, or an integral connection; may be a mechanical connection or an electrical connection; and may be a direct connection or an indirect connection through an intermediate medium, or may be internal communication between two elements or interaction between the two elements. A person of ordinary skill in the art may understand the specific meanings of the foregoing terms in this application according to specific situations.

In this application, "and/or" describes only an association relationship for describing associated objects and represents that three relationships may exist. For example, A and/or B may represent three instances: A exists alone, A and B coexist, or B exists alone. In addition, the character "/" herein generally indicates an "or" relationship between the associated objects.

It should be noted that, in this application, the terms, such as "in some embodiments", "exemplarily", or "for example", are used to represent giving an example, an illustration, or a description. In this application, any embodiment or design scheme described by using "in some embodiments", "exemplarily", or "for example" should not be explained as being more preferred or having more advantages than another embodiment or design scheme. Exactly, use of the terms, such as "in some embodiments", "examplarily", and "for example", is intended to present a relative concept in a specific manner.

To make the objectives, technical solutions, and advantages of this application clearer, the following further describes this application in detail with reference to the accompanying drawings and the embodiments.

A SIM card tray and a circuit board in a mobile device are arranged in two manners. One manner is that the SIM card tray and the circuit board are integrally arranged, that is, the SIM card tray is directly electrically connected to the circuit board. This solution has the advantage of low costs, but the SIM card tray and the circuit board are stacked in a thickness direction, and therefore, a large thickness space needs to be occupied. The other manner is that the SIM card tray and the circuit board are arranged in a separated manner, a flexible circuit board is arranged on the SIM card tray, and the SIM card tray is electrically connected to the circuit board on the terminal device by using the flexible circuit board. The manner has the advantages that a thickness space can be further compressed, which is applicable to a terminal device with a higher requirement for lightening and thinning.

The flexible circuit board naturally features that the flexible circuit board can be bent, to adapt to a narrow mounting space in the terminal device. That is, the flexible circuit board needs to be bent moderately in an electrical connection process. However, when the flexible circuit board is bent, a joint between the flexible circuit board and the SIM card tray may be warped. If a pad is arranged in a warped region, a risk of dropping is caused. Therefore, to not reduce a welded connection strength between the pad and the SIM card tray, generally, an avoidance width of 0.5 to 1 mm needs to be reserved between the flexible circuit board and the pad in a bending direction. In this way, more reserved space is needed in a transverse direction (length or width direction) of a mobile terminal for arrangement of the SIM card tray and the circuit board in a separated manner. This is not conducive to miniaturization of the mobile terminal.

In view of this, an embodiment of this application provides a SIM card tray, including a base and a flexible circuit board, where a plurality of pads are arranged on the base, and an end of the flexible circuit board is connected to one of the edge side portions of the base. In addition, a projection of a bending start position of the flexible circuit board on a current edge side portion does not coincide with a projection of a corresponding pad on the same edge side portion. In this way, when the flexible circuit board is bent due to a need to connect the flexible circuit board to the circuit board of the mobile device, the bending start position of the flexible circuit board is misaligned with the arranged pads, which can reduce or eliminate stress concentration generated at welding joints of the pads due to bending of the flexible circuit board. Finally, miniaturization of the mobile device is further facilitated while the service life of the SIM card tray is improved.

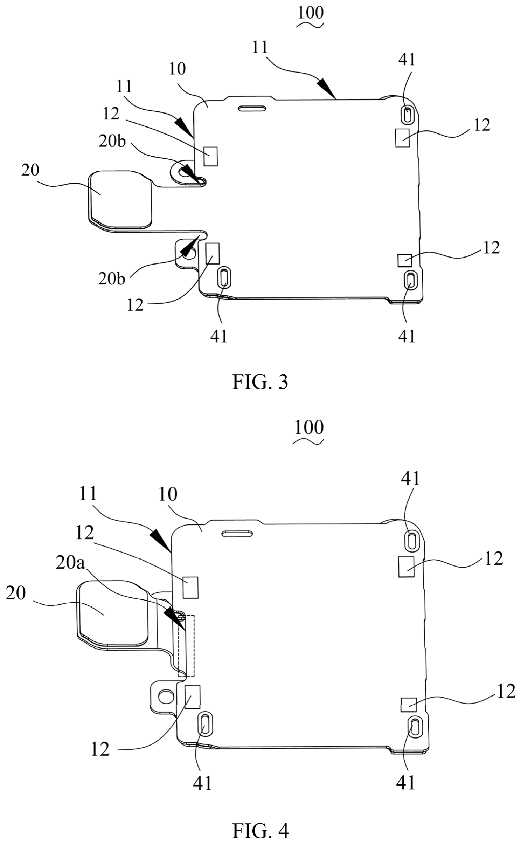

Refer to FIG. 3 and FIG. 4. FIG. 3 is a schematic diagram of a structure of a SIM card tray 100 according to some embodiments of this application. A flexible circuit board of the SIM card tray is in a straightened state. FIG. 4 is another schematic diagram of a structure of a SIM card tray 100 according to some embodiments of this application. A flexible circuit board of the SIM card tray is in a bent state. The SIM card tray 100 includes a base 10 and a flexible circuit board 20. The base 10 has edge side portions 11, and a plurality of pads 12 are arranged on the base 10. Each pad 12 is close to an edge side portion 11. An end of the flexible circuit board 20 is connected to one of the edge side portions 11, and a projection of a bending start position 20a of the flexible circuit board 20 on a current edge side portion 11 does not coincide with a projection of a corresponding pad 12 on the same edge side portion 11.

It may be understood that the base 10 has a corresponding circuit structure. In addition to an electrical connection relationship, there is also a spatial location connection relationship between the base 10 and the flexible circuit board 20. Herein, the base 10 and the flexible circuit board 20 may be two independent parts, and are connected by using a corresponding connection process. Alternatively, the base 10 and the flexible circuit board 20 are manufactured by using an integral forming process. The flexible circuit board 20 is configured to be connected to a main control circuit board of the terminal device, to implement electrical signal transmission between the SIM card tray 100 and the main control circuit board.

The base 10 may be of a sheet structure or a plate structure. Therefore, the base 10 has a plurality of edge side portions 11, and each edge side portion 11 is an edge of the base 10. The flexible circuit board 20 is arranged on one of the edge side portions 11. In addition, each pad 12 is connected to the base 10 by welding and is close to a corresponding edge side portion 11. For example, the base 10 is of a square sheet structure or approximately of a square sheet structure. In this case, the base 10 has four edge side portions 11, and each pad 12 is arranged close to a corresponding edge side portion 11. In addition, an end of the flexible circuit board 20 is connected to one of the edge side portions 11.

The bending start position 20a of the flexible circuit board 20 refers to a part of the flexible circuit board 20 connected to the edge side portion 11, and may be believed as an imaginary line segment, specifically a black solid line framed by a dashed line in the figure. The line segment is a part of the flexible circuit board 20 coinciding with the edge side portion 11. Once the flexible circuit board 20 needs to be bent, the bending start position 20a is also a part at which the flexible circuit board 20 is bent first, and therefore causes a certain amount of deformation or wrinkling in the current edge side portion 11 and a region around the edge side portion 11.

That a projection of a bending start position 20a of the flexible circuit board 20 on a current edge side portion 11 does not coincide with a projection of a corresponding pad 12 on the same edge side portion 11 means that the projections of the bending start position 20a of the flexible circuit board 20 and the corresponding pad 12 on the same edge side portion 11 are misaligned. In this way, when the flexible circuit board 20 is bent, the pad 12 may be away from a deformed or wrinkled region of the base 10, and the pad 12 may be arranged closer to the current edge side portion 11. That is, a width that needs to be reserved between the edge side portion 11 and the pad 12 may be less than or far less than 0.5 mm.

For example, there is only one pad 12 close to the current edge side portion 11 connected to the flexible circuit board 20. That is, the bending start position 20a of the flexible circuit board 20 is misaligned with the pad 12.

For example, when a plurality of pads 12 are close to the current edge side portion 11 connected to the flexible circuit board 20, the bending start position 20a of the flexible circuit board 20 is located between any two adjacent pads 12, so as to be misaligned with the current two pads 12.

In the SIM card tray 100 according to the embodiment of this application, the flexible circuit board 20 is arranged on the edge side portions 11 of the base 10. In addition, the projection of the bending start position 20a of the flexible circuit board 20 on the current edge side portion 11 does not coincide with the projection of the corresponding pad 12 on the same edge side portion 11. That is, the bending start position 20a of the flexible circuit board 20 is misaligned with a position of the corresponding pad 12 on the current edge side portion 11. In this way, when the flexible circuit board 20 is bent during connection to a circuit board of the terminal device, the flexible circuit board 20 does not drive the welding region of the base 10 at which the corresponding pad 12 is located, or only drives part of the welding region of the base 10 at which the corresponding pad 12 is located. Therefore, there is less stress on the pad 12 in the welding region of the base 10, the pad 12 is not susceptible to dropping, and welding reliability is higher.

In some embodiments, only one of the pads 12 is close to the current edge side portion 11, and is misaligned with the bending start position 20a of the flexible circuit board 20.

It may be understood that in a side length direction of the current edge side portion 11, the projection of the pad 12 on the current edge side portion 11 is misaligned with the projection of the bending start position 20a of the flexible circuit board 20 on the current edge side portion 11. That is, viewed from a two-dimensional perspective, the projection of the pad 12 on the current edge side portion 11 is a line segment, the projection of the bending start position 20a of the flexible circuit board 20 on the current edge side portion 11 is another line segment, and the two line segments are disconnected in the side length direction of the current edge side portion 11.

In this way, the bending start position 20a of the flexible circuit board 20 can avoid the current pad 12, so that there is less stress on the current pad 12 in a welding region of the base 10, and welding reliability is higher.

Referring to FIG. 4, two pads 12 are close to the current edge side portion 11 at an interval, and the bending start position 20a of the flexible circuit board 20 is located between the current two pads 12.

It may be understood that in the side length direction of the current edge side portion 11, projections of the two pads 12 on the current edge side portion 11 are misaligned with the projection of the bending start position 20a of the flexible circuit board 20 on the current edge side portion 11. That is, viewed from a two-dimensional perspective, the projections of the two pads 12 on the current edge side portion 11 are two line segments, respectively, the projection of the bending start position 20a of the flexible circuit board 20 on the current edge side portion 11 is a third line segment, and the above three line segments are disconnected in pairs in the side length direction of the current edge side portion 11.

It should be noted that the two pads 12 are close to the current edge side portion 11 at an interval, which may be that a line connecting geometric centers of the two pads 12 is parallel to the side length direction of the current edge side portion 11, or forms a certain included angle therewith.

Optionally, the two pads 12 are close to the current edge side portion 11 at an interval, and the line connecting the geometric centers of the two pads 12 is parallel to the side length direction of the current edge side portion 11. In addition, distances between the geometric centers of the two pads 12 and the current edge side portion 11 are equal.

In this way, the bending start position 20a of the flexible circuit board 20 can avoid the current two pads 12, so that there is less stress on the current two pads 12 in a welding region of the base 10, and welding reliability is higher.

In another embodiment, there may alternatively be three or more pads 12, the pads 12 are close to the current edge side portion 11 at intervals, and the bending start position 20a of the flexible circuit board 20 is located between any two pads 12.

In some embodiments, distances between two opposite ends of the bending start position 20a of the flexible circuit board 20 and corresponding pads 12 are the same.

It may be understood that, in the side length direction of the current edge side portion 11, the projection of the bending start position 20a of the flexible circuit board 20 on the current edge side portion 11 is a line segment. Therefore, the line segment has a first end and a second end, and a distance between the first end and the second end is a length of the line segment.

That distances between the first end and second end of the line segment and corresponding pads 12 are equal means that distances between the first end and second end of the line segment and geometric centers of the corresponding pads 12 are the same.

Alternatively, in the side length direction of the current edge side portion 11, projections of the two pads 12 on the current edge side portion 11 are two line segments, respectively, and that distances between two opposite ends of the bending start position 20a of the flexible circuit board 20 and corresponding pads 12 are the same may mean that distances between the first end and second end of the line segment and one end of either of the other two line segments in the side length direction of the current edge side portion 11 are equal.

In this way, magnitudes of pulling forces on the two pads 12 by the two opposite ends of the bending start position 20a of the flexible circuit board 20 are the same or basically the same. Therefore, stresses on the two pads 12 in the welding region of the base 10 are approximately the same, which can also improve welding reliability to a certain extent.

In some embodiments, one end of the bending start position 20a of the flexible circuit board 20 is close to one of the pads 12, and the other end thereof is away from the other pad 12.

It may be understood that, in the side length direction of the current edge side portion 11, the projection of the bending start position 20a of the flexible circuit board 20 on the current edge side portion 11 is a line segment. Therefore, the line segment has a first end and a second end, and a distance between the first end and the second end is a length of the line segment.

That distances between the first end and second end of the line segment and corresponding pads 12 are not equal means that distances between the first end and second end of the line segment and geometric centers of the corresponding pads 12 are not the same. That is, the differentiated setting is mainly to adapt to a differentiated setting of a welded connection strength of each pad 12 on the base 10.

For example, contact surfaces between the two pads 12 and the base 10 are differentiated. Therefore, welded connection strengths of the two pads 12 on the base 10 are different. In this case, a distance between the first end of the line segment and the geometric center of the pad 12 with a larger contact area is greater than a distance between the second end thereof and the geometric center of the pad 12 with a larger contact area, to reduce an impact of the bending start position 20a of the flexible circuit board 20 on welding stability of the two pads 12 during welding.

Alternatively, in the side length direction of the current edge side portion 11, projections of the two pads 12 on the current edge side portion 11 are two line segments, respectively, and that distances between two opposite ends of the bending start position 20a of the flexible circuit board 20 and corresponding pads 12 are not equal may mean that distances between the first end and second end of the line segment and one end of either of the other two line segments in the side length direction of the current edge side portion 11 are not equal. Similarly, this solution is only different in defining the above-mentioned distance, and can also reduce the impact of the bending start position 20a of the flexible circuit board 20 on welding stability of the two pads 12 during bending.

In this way, there is a differentiated setting for the pulling forces on the two pads 12 by the two opposite ends of the bending start position 20a of the flexible circuit board 20, which is suitable for scenarios with different sizes or different welding strengths of the two pads 12.

Referring to FIG. 3 and FIG. 4, in some embodiments, a crack arrest groove 20b is provided at any one of the two opposite ends of the bending start position 20a of the flexible circuit board 20.

When no crack arrest groove 20b is provided, a joint between the bending start position 20a of the flexible circuit board 20 and the base 10 is at a right angle or approximately a right angle. Once the bending start position 20a of the flexible circuit board 20 is bent, the joint therebetween is susceptible to tearing or cracking due to stress concentration.

It may be understood that, in the side length direction of the current edge side portion 11, the projection of the bending start position 20a of the flexible circuit board 20 on the current edge side portion 11 is a line segment. Therefore, the line segment has a first end and a second end, and a distance between the first end and the second end is a length of the line segment. Providing the crack arrest groove 20b at the first end and/or the second end can reduce the stress concentration at the joint between the bending start position 20a of the flexible circuit board 20 and the base 10.

For example, the crack arrest groove 20b is provided at the first end of the bending start position 20a of the flexible circuit board 20, or the crack arrest groove 20b is provided at the second end of the bending start position 20a of the flexible circuit board 20, or crack arrest grooves 20b are provided at the two opposite ends of the bending start position 20a of the flexible circuit board 20.

In this way, the crack arrest groove 20b is configured to reduce the stress at the joint between the flexible circuit board 20 and the base 10 during bending and prolong the service life of the flexible circuit board 20.

In some embodiments, a groove wall of the crack arrest groove 20b is provided in an arc shape.

It may be understood that, that a groove wall of the crack arrest groove 20b is provided in an arc shape is more suitable for meeting requirements for bending of the flexible circuit board 20.

Optionally, the crack arrest grooves 20b provided at the two opposite ends of the bending start position 20a of the flexible circuit board 20 each are provided in an arc shape, and the two arc-shaped crack arrest grooves 20b have the same curvature and dimension parameter, such that stresses at joints between the two opposite ends of the bending start position 20a of the flexible circuit board 20 and the base 10 are the same or approximately the same.

In this way, stress concentration of the arc-shaped crack arrest grooves 20b is less and a crack arrest effect is better.

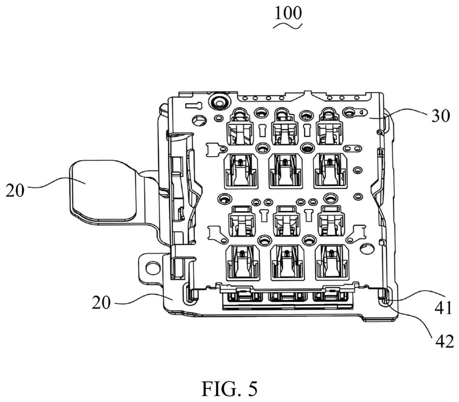

Referring to FIG. 5, in some embodiments, the SIM card tray 100 further includes a card slot holder 30. The card slot holder 30 is arranged on the base 10, and the card slot holder 30 is electrically connected to the base 10 through each pad 12.

It may be understood that the card slot holder 30 is configured for a SIM card to be inserted in. Specifically, a terminal fitting with a contact of the SIM card is arranged on the card slot holder 30.

In this way, the card slot holder 30 is configured for the SIM card to be inserted in, and is electrically connected to the base 10 through each pad 12.

Referring to FIG. 5, in some embodiments, a mounting portion 41 is arranged on the base 10, and a mounting fitting portion 42 fitting with the mounting portion 41 is arranged on the card slot holder 30.

The mounting portion 41 may be of a hole structure arranged on the base 10, and the mounting fitting portion is of a shaft structure arranged on the card slot holder 30. That is, the mounting portion is connected to the mounting fitting portion by hole-shaft fitting.

Alternatively, the mounting portion 41 may be of a shaft structure arranged on the base 10, and the mounting fitting portion is of a hole structure arranged on the card slot holder 30. That is, the mounting portion is connected to the mounting fitting portion by hole-shaft fitting.

In this way, through the fit connection between the mounting portion 41 and the mounting fitting portion 42, connection stability between the card slot holder 30 and the base 10 is further improved.

Referring to the figure, in a specific embodiment, the mounting portion 41 includes a mounting hole provided in the base 10, and the mounting fitting portion 42 includes a hook arranged on the card slot holder 30.

It may be understood that the hook is snap-fitted in the mounting hole, to connect the base 10 to the card slot holder 30.

Optionally, the base 10 and the card slot holder 30 each are of a square sheet structure or approximatively of a square sheet structure, and there are three mounting holes, which are provided at any three vertexes of the base 10, respectively. Similarly, hooks are arranged at three corresponding vertexes of a snap-fit holder.

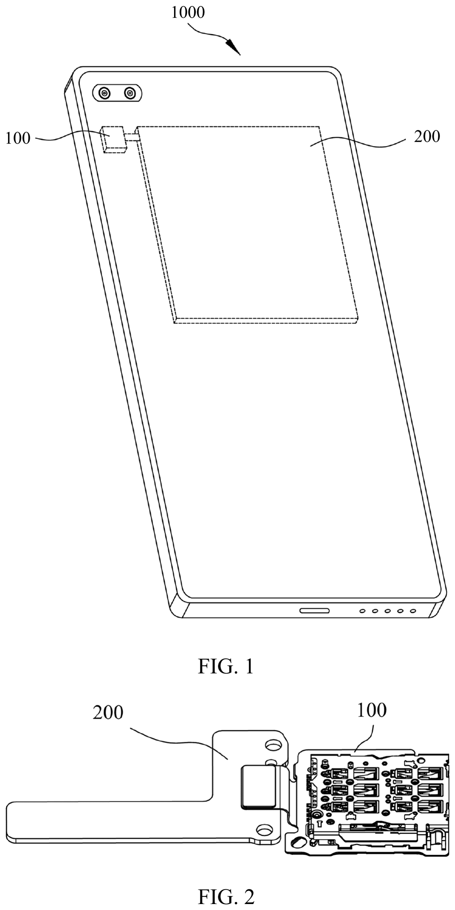

Referring to FIG. 1, an embodiment of this application further provides a terminal device 1000, including the above SIM card tray 100.

In the terminal device 1000 according to the embodiment of this application, based on the above SIM card tray 100, the terminal device 1000 may have a smaller thickness, which is more conducive to miniaturization.

The terminal device 1000 according to the embodiment of this application may be a mobile phone, a tablet computer, a laptop computer (laptop), a notebook computer (notebook PC), a personal digital assistant (personal digital assistant, PDA), a wearable device (for example, a watch), an in-vehicle device, an augmented reality (augmented reality, AR) device / virtual reality (virtual reality, VR) device, a point of sales terminal (POS, Point of sales terminal), an event data recorder, a walkie-talkie, a camera, a display, or the like, but is not limited thereto.

Refer to FIG. 1 and FIG. 2. FIG. 1 is a schematic diagram of a structure of a terminal device 1000 according to some embodiments of this application. In this embodiment of this application, description is made by using an example in which the terminal device 1000 is a mobile phone.

The terminal device 1000 further includes a main control circuit board 200, and a port is arranged on the main control circuit board 200. An insertion end of the flexible circuit board 20 of the SIM card tray 100 fits with the port. In this way, the main control circuit board 200 and the SIM card tray 100 may be arranged side by side in a length direction or a width direction of the terminal device 1000. In addition, the flexible circuit board 20 of the SIM card tray 100 has a higher bending degree, and the main control circuit board 200 and the SIM card tray 100 may be arranged more compactly. This is more conducive to miniaturization of the terminal device 1000.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

## Claims

1. A SIM card tray, comprising a base and a flexible circuit board, wherein the base has edge side portions, a plurality of pads are arranged on the base, each pad is close to an edge side portion, an end of the flexible circuit board is connected to one of the edge side portions, and a projection of a bending start position of the flexible circuit board on a current edge side portion does not coincide with a projection of a corresponding pad on the same edge side portion.

2. The SIM card tray according to claim 1, wherein only one of the pads is close to the current edge side portion, and is misaligned with the bending start position of the flexible circuit board.

3. The SIM card tray according to claim 1, wherein two pads are close to the current edge side portion at an interval, and the bending start position of the flexible circuit board is located between the current two pads.

4. The SIM card tray according to claim 3, wherein distances between two opposite ends of the bending start position of the flexible circuit board and corresponding pads are the same.

5. The SIM card tray according to claim 3, wherein one end of the bending start position of the flexible circuit board is close to one of the pads, and the other end thereof is away from the other pad.

6. The SIM card tray according to any one of claims 1 to 5, wherein a crack arrest groove is provided at any one of the two opposite ends of the bending start position of the flexible circuit board.

7. The SIM card tray according to claim 6, wherein a groove wall of the crack arrest groove is provided in an arc shape.

8. The SIM card tray according to any one of claims 1 to 5, further comprising a card slot holder, wherein the card slot holder is arranged on the base, and the card slot holder is electrically connected to the base through each pad.

9. The SIM card tray according to claim 8, wherein a mounting portion is arranged on the base, and a mounting fitting portion fitting with the mounting portion is arranged on the card slot holder.

10. The SIM card tray according to claim 9, wherein the mounting portion comprises a mounting hole provided in the base, and the mounting fitting portion comprises a hook arranged on the card slot holder.

11. A terminal device, comprising the SIM card tray according to any one of claims 1 to 10.
